# EUROPEAN PATENT SPECIFICATION

(11) **EP 0 674 380 B1**
(45) Date of publication and mention of the grant of the patent: **06.05.1999**
(21) Application number: 95301804.1
(22) Date of filing: 17.03.1995
(51) Int. Cl.: H02M 1/00

(54) **Parallel connection structure for flat type semiconductor switches**
Struktur einer Parallelschaltverbindung für flache Halbleiterschalter
Structure d'une connexion en parallèle pour des commutateurs flats à semi-conducteur

(30) Priority: 24.03.1994 JP 52397/94
(43) Date of publication of application: 27.09.1995
(73) Proprietor: FUJI ELECTRIC CO. LTD., Kawasaki 210 (JP)
(72) Inventor: Nomura, Toshihiro, Kawasaki-ku, Kawasaki 210 (JP); Hisamoto, Masaaki, Kawasaki-ku, Kawasaki 210 (JP); Kurata, Iwao, Kawasaki-ku, Kawasaki 210 (JP)
(74) Representative: Bridge-Butler, Alan James

(56) References cited:
- US-A- 4 612 561
- US-A- 5 132 896
- PATENT ABSTRACTS OF JAPAN, unexamined applications, E field, vol. 18, no. 263, May 19, 1994 THE PATENT OFFICE JAPANESE GOVERNMENT page 67 E 1550; & JP-A-06 038 507 (FUJI ELECTRIC CO. LTD.)

## Description

The present invention relates to the connection in parallel of a plurality of flat type semiconductor switches, which enables the semiconductor switches to switch on and off simultaneously and at high speed without causing switching time differences.

Semiconductor switches have facilitated easy and smooth conversion of DC power to AC, and vice versa. However, as each individual semiconductor switch has a limited capacity, which limits the wattage of electrical power convertible by that semiconductor switch, the power conversion capacity of a semiconductor switching apparatus is increased by connecting many semiconductor switches in parallel.

US-A-4 612 561 discloses various ways of connecting together a plurality of semi-conductor switches. Some of the switches have a first electrode formed on a first surface and second and third electrodes protruding from a second surface. Other disclosed switches have first and second electrodes formed on first and second opposite surfaces and a third electrode on a side surface.

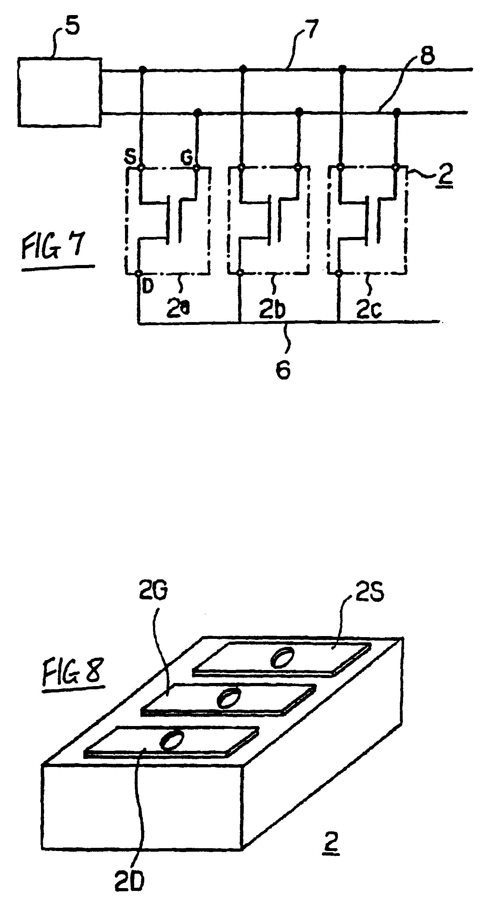

Figure 7 is a circuit diagram showing an example of a general circuit which connects a plurality of semiconductor switches in parallel. In Figure 7, three semiconductor switches 2a, 2b, and 2c of the type shown in Figure 8 (see also US-A-5 132 896) have their source electrodes 2S connected to a common source line 7 and theira gate electrodes 2G are connected to a common gate line 8. The drain electrodes 2D of the semiconductor switches 2a, 2b, and 2c are commonly connected to a drain line 6.

Since it is necessary in power conversion for the semiconductor switches to switch on and off simultaneously, the source line 7 and the gate line 8 are connected with a gate drive circuit 5. When the gate drive circuit 5 applies a positive voltage between the gate electrode and the source electrode, an on-current flows from the gate electrode to the source electrode of each of the semiconductor switches 2a, 2b, 2c, and the three semiconductor switches turn on simultaneously. Conversely, when the gate drive circuit 5 stops applying the on-voltage or applies voltage opposite in polarity to the on-voltagebetween the gate electrode and the source electrode, an off-current flows from the source electrode to the gate electrode of each of the semiconductor switches 2a, 2b, 2c, and the semiconductor switches turn off simultaneously.

When the gate drive circuit 5 and the semiconductor switches 2a, 2b, 2c are connected in the same manner as described in Figure 7, the length of the gate line 8 between the gate drive circuit 5 and the gate electrode 2G of the semiconductor switch 2b is longer than the length of the gate line 8 between the gate drive circuit 5 and the gate electrode 2G of the semiconductor switch 2a. Likewise, the line length between the gate drive circuit 5 and the gate electrode 2G of the semiconductor switch 2c is much longer than the line length between the gate drive circuit 5 and the gate electrode 2G of the semiconductor switch 2a.

For example, when the line length between the gates of neighbouring semiconductor switches is several tens of centimetres, the wiring inductance L of the gate line 8 and the source line 7 can be up to several hundreds of nanoHenrys. Furthermore, the static capacitance C of the gate of a large capacity semiconductor switch capable of tolerating several hundreds of Amperes and several hundreds of Volts is usually in the region of several hundreds of nanoFarads.

The transmission delay time for an (on-current) signal from the gate drive circuit 5 between the neighbouring gate electrodes is almost proportional to a root of the product of the wiring inductance L and the static gate capacitance C. Therefore, when a plurality of semiconductor switches are connected in parallel and when the wiring inductance L and the static gate capacitance C are the above described values, the transmission delay time can amount to several hundreds of nanoseconds.

Since the wiring inductance causes signal transmission delay between the semiconductor switches, for example 2a and 2c, in the parallel circuit of Figure 7, the signal transmission delay further causes timing differences of several hundreds of nanoseconds or more in the on-off operations between the semiconductor switches 2a and 2c. Since, during the transition from ON to OFF, the turn-off current localizes to a semiconductor switch which switches off later than the others, turn-off loss localizes to this more slowly acting semiconductor switch. Similarly, if one semiconductor switch which switches on earlier than the others, then during the transition from OFF to ON, turn-on current localizes to that semiconductor switch.

Since the losses localize to particular semiconductor switches if a timing difference exists in the on-off switching operation, then the advantage of connecting many semiconductor switches in parallel is lost. It has also been found that, even when many semiconductor switches are connected in parallel, convertible electric power never increases so much as intended.

The use of thick gate line conductors for reducing wiring inductance requires wider spaces for wiring and connection. The connection of thick lines is not an easy task. Since the inductance of the main circuit conductors (anode side wiring and cathode side wiring) in a semiconductor switching apparatus for high electric power conversion should be small, it is not permissible to leave space around the semiconductor switches through which excessive magnetic flux can pass. This in turn makes it difficult to provide a space for screw-connecting or for soldering connections for the conductors.

In view of the foregoing, an object of the present invention is to prove a parallel connection structure for a plurality of semiconductor switches which facilitates reducing both the wiring inductance between the control electrodes, and the operation time variation of the semiconductor switches.

The object of the present invention is achieved by adopting a laminate structure which presses and contacts a plate like first conductor to the respective first electrodes formed on the first surface of each semiconductor switch, and presses a stripe conductor of a second conductor into with the respective second electrode protruding from the second surface of the semiconductor switch; and contacts a plurality of thin and wide film conductors with resilient third electrodes, formed on the second surfaces of the respective semiconductor switches and insulated from their respective second electrodes, by the spring force of the third electrodes.

Alternatively, the second conductor may be replaced by a third conductor which is formed as a stripe conductor; a plurality of fins protruding from and bent toward the stripe conductor; plurality of bent film conductors, the first bent halves of which are inserted between the stripe conductor and the fins, and the second bent halves of which are exposed toward the third electrode; and insulating means for insulating the film conductors from the stripe conductor and the fins.

The conductor for the second electrodes and the film conductors for the third electrodes constructed and laminated as described above facilitate reducing the inductance of the film conductors by two orders of magnitude or more.

The present invention will now be described in detail, with reference to the accompanying drawing figures which illustrate the preferred embodiments of the present invention. Throughout the drawing figures, like parts are designated by the same reference numerals. In the Figures:
Figure 1 is a circuit diagram showing a schematic layout of a connection structure according to the present invention;
Figure 2 is a plan view of a first embodiment of the present invention;
Figure 3 is a side view of the structure of Figure 2;
Figure 4 is an end view of the structure of Figure 2;
Figure 5 is a perspective view of the external structure of the semiconductor switch used in the embodiments of the present invention;
Figure 6 is a diagram showing a second embodiment of the present invention;
Figure 7 is a diagram showing an outline example of a general circuit which connects a plurality of semiconductor switches in parallel; and
Figure 8 is a diagram showing the external structure of the semiconductor switch used in the prior art.

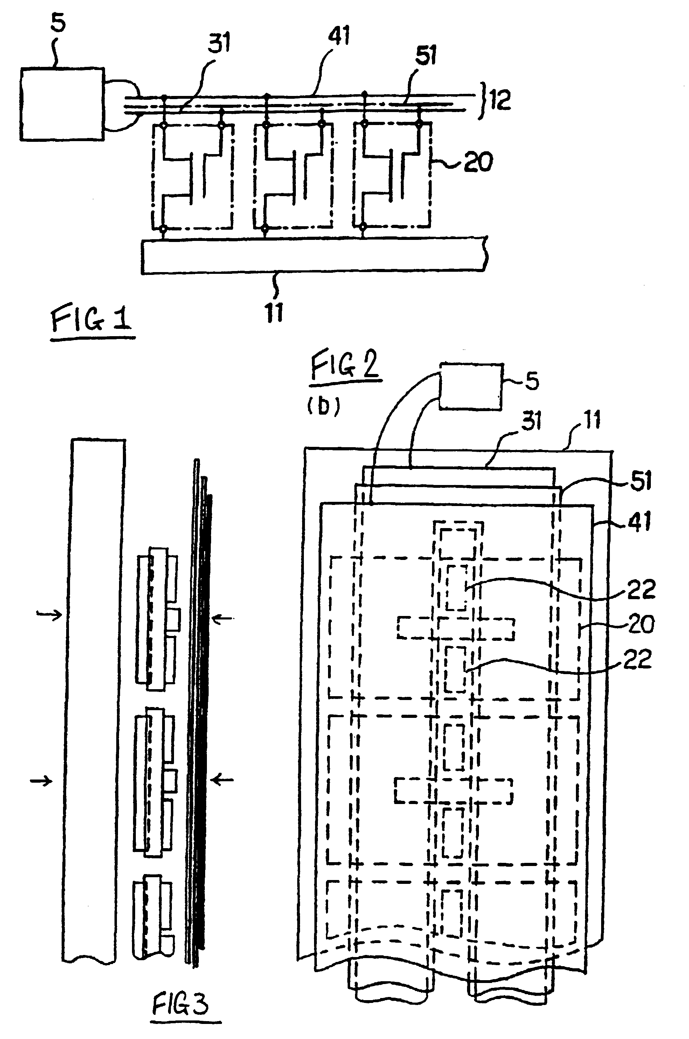

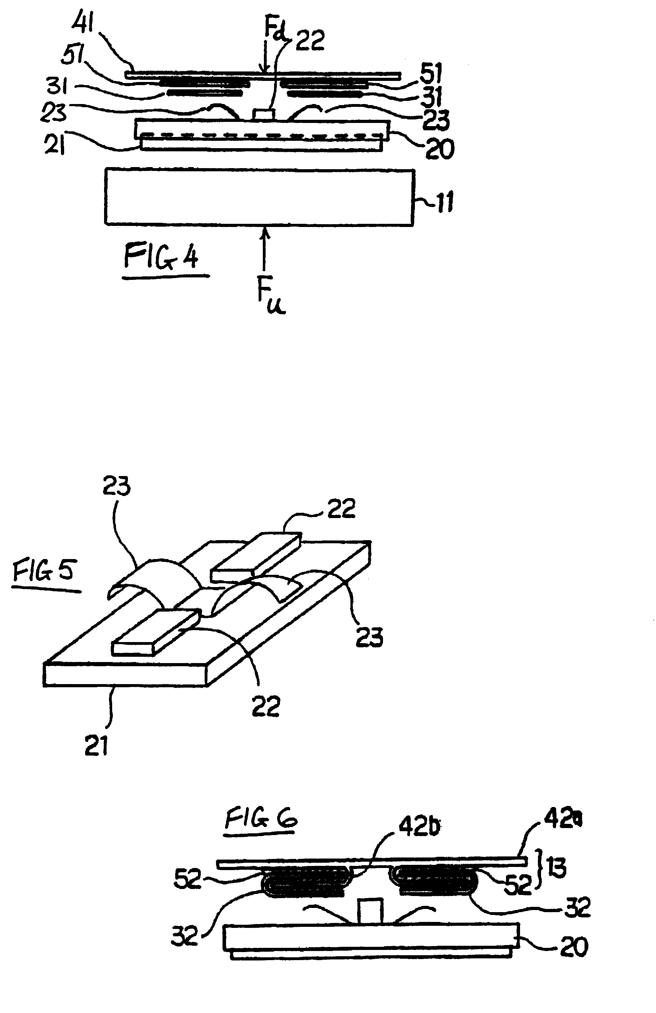

Referring now to the drawings, Figure 1 is a circuit diagram showing an outline of a connection structure according to the present invention which connects in parallel a plurality of semiconductor switches 20 shown in Figure 5. Each of the semiconductor switches 20 may be, for example, a MOSFET or an IGBT. The connection structure of Figure 1 is different from that of Figure 7 in that drain electrodes, source electrodes and gate electrodes are respectively connected with a wide drain conductor 11, a wide source conductor 41 and wide and thin film gate conductors 31. The source conductor 41 and the film gate conductors 31 are laminated together but are separated electrically by insulator film 51.

Figures 2 3 and 4 show a first embodiment of the present invention which connects a plurality of the semiconductor switches 20 shown in Figure 5 in parallel. As shown in Figure 4, the drain conductor plate 11 as the first conductor is pressed by a pressing means (not shown) in an upward direction indicated by an arrow Fu, and contacts a drain electrode 21 of the semiconductor switch 20. The source conductor stripe 41 is pressed downwardly in the direction indicated by an arrow Fd, and contacts with a source electrode 22.

The gate conductor films 31 are pressed into close contact with the gate electrodes 23 by the action of the spring force which resists downward deflection of the resilient gate electrodes. The gate conductor films 31 are insulated from the source conductor 41 by thin insulator films 51. The gate conductor films 31, the source conductor stripe 41, and the insulator 51 constitute the second conductor means 12.

When a semiconductor switch has, as in the first embodiment, a plurality of gate electrodes 23 and when the gate electrodes 23 are driven by the same signal, inductance of the gate conductor films is halved by connecting the gate conductor films 31 at their ends with connecting means made from the same material as the gate conductor films 31, or by forming the gate conductor film in a rectangular loop.

When the gate electrodes 23 are driven by different signals so as to perform different operations, the end connection is unnecessary.

In the first embodiment, the film gate conductors 31 are connected together at their ends, a gate drive circuit 5 is connected between the source conductor 41 and the gate conductor films 31, and a signal is fed to the gate electrodes 23.

Since the insulator films 51 are inserted between the source conductor stripe 41 and the gate conductor films 31, the inductance of the gate conductor films 31 is smaller than it would be if the connection were made by wires.

Figure 6 shows a second embodiment of the present invention which connects in parallel a plurality of semiconductor switches of Figure 5.

In the second embodiment, a source conductor 42 comprises a thick conductor plate 42a and fins 42b which are thinner than the conductor plate 42a and extend out of the conductor plate 42a. Each fin 42b is bent near its root, so as to extend in a plane spaced from and substantially parallel to the conductor plate 42. The gate conductor film 32 is bent in half to form a channel, which has one side positioned between the fin 42b and the conductor plate 42a, and its other side positioned on the side of the fin 42b remote from the conductor plate 42a. The conductor plate 42a and the fins 42b are insulated from the gate conductor film 32 by means of insulator films 52 interposed therebetween.

On the side of the conductor plate 42a to which the fins 42b are connected, and which is remote from the side to which the source conductor 42 is pressed, a half of the gate conductor film 32 is exposed and faces toward the gate electrode 23. The thus assembled source conductor 42, including the conductor plate 42a and fins 42b, and the gate conductor films 32 constitute a second conductor means 13. Each fin 42b corresponds in position to one of the gate electrodes 23 of each semiconductor switch 20, and ensures that gate conductor film 32 the closely contacts the gate electrodes 23.

In the same way as in the first embodiment, the conductor plate 42a of the source conductor 42 contacts with the source electrode 22, and the drain conductor 11 contacts the drain electrode 21, under the pressure exerted by a pressing means (not shown). And, the exposed half of the bent gate conductor film 32 is contacted tightly with the gate electrode 23 by the resilient force of the deformed elastic gate electrode 23. As explained above, the gate drive circuit 5 is connected between the source conductor 42 and the gate conductor films 32 in this embodiment.

Since, in the second embodiment, the source conductor 42 comprises the thick conductor plate 42a and the bent thin fins 42b, between which the bent halves of the gate conductor films 32 are inserted and insulated by the insulator films 52, the magnetic path along the fins 42b and the gate conductor films 32 is elongated. Due to this, magnetomotive force generated by the gate current in the fins 42b and the magnetomotive force generated in the gate conductor films 32 compensate for each other. Therefore, the second embodiment is much more effective in reducing the wiring inductance than either the arrangement of first embodiment or connection by wires.

When the semiconductor switch 20 is a thyristor, the first electrode is an anode, the second electrode a cathode, and the third electrode a gate electrode. And, when the semiconductor switch 20 is a bipolar transistor, the first electrode is a collector electrode, the second electrode an emitter electrode, and the third electrode a base electrode.

Since the wide gate conductor films and the wide source conductor, through which the on-off signals flow from the gate drive circuit to the gate electrodes, are tightly fixed through the thin insulator film, and since this arrangement compensates for the magnetomotive force generated by the gate current, the parallel connection structure according to the present invention limits the wiring inductance to levels as low as several nanoHenrys even when five or ten semiconductor switches are connected in parallel.

As a consequence of this, since the signal transmission delay caused by the gate wiring inductance is limited to less than several tens of nanoseconds, much shorter than that produced either by using the conventional wiring techniques of the prior art, then both the turn-on loss and the turn-off loss of the semiconductor switching array are reduced.

As a result, since the convertible electric power can be increased in proportion to the numbers of the semiconductor switches connected in parallel, the present invention facilitates the construction of large capacity power converting apparatus.

By widening the areas in which the source conductor and the gate conductor films face each other through the insulator, the gate wiring inductance is further reduced and the turn-on and the turn-off losses of the semiconductor switch are further reduced.

The pressed contact, adopted in the present invention in place of screwing and soldering, reduces the labour and work space for wiring connections involved in production, and facilitates not only down-sizing the semiconductor switching apparatus but also further reduction of the gate wiring inductance.

The present invention is also applicable for connecting a plurality of thyristors or bipolar transistors in a parallel array.

## Claims

1. A parallel connection structure for connecting in parallel a plurality of flat, plate-like semiconductor switches (20), each thereof including a first electrode (21) formed on a first surface of said semiconductor switch, a second electrode (22) protruding from a second surface of said semiconductor switch, and a plurality of resilient third electrodes (23) formed on said second surface and insulated from said second electrode, said parallel connection structure comprising:
a plate-like first conductor (11); and
a second conductor means (12) comprising a stripe conductor (41), and a plurality of film conductors (31) laminated with said stripe conductor and separated therefrom electrically by an insulator (51),
said first conductor and said second conductor means being pressed toward each other, whereby to establish pressed contact of said first conductor with said first electrodes and said stripe conductor with said second electrodes, and to contact said film conductors with said third electrodes individually by the spring force thereof.

2. A parallel connection structure as claimed in claim 1, further comprising connecting means, made of the same material as said film conductors, for connecting said film conductors at respective ends thereof.

3. A parallel connection structure as claimed in claim 1 or claim 2, wherein said semiconductor switch comprises a MOSFET, said first electrode comprises a drain electrode, said second electrode comprises a source electrode, and said third electrode comprises a gate electrode.

4. The parallel connection structure as claimed in claims 1 or 2, wherein said semiconductor switch comprises an IGBT,said first electrode comprises a drain electrode, said second electrode comprises a source electrode, and said third electrode comprises a gate electrode.

5. The parallel connection structure as claimed in claims 1 or 2, wherein said semiconductor switch comprises a thyristor, said first electrode comprises an anode, said second electrode comprises a cathode, and said third electrode comprises a gate electrode.

6. The parallel connection structure as claimed in claims 1 or 2, wherein said semiconductor switch comprises a bipolar transistor said first electrode comprises a collector electrode, said second electrode comprises an emitter electrode, and said third electrode comprises a base electrode.

7. A parallel connection structure for connecting in parallel a plurality of flat, plate-like semiconductor switches (20), each thereof including a first electrode (21) formed on a first surface of said semiconductor switch, a second electrode (22) protruding from a second surface of said semiconductor switch, and a plurality of elastic third electrodes (23) formed on said second surface and insulated from said second electrode, said parallel connection structure comprising a plate-like first conductors (11) and a second conductor means (13) comprising a stripe conductor (42a), a plurality of fins (42b) protruding from and bent toward said stripe conductor, a plurality of bent film conductors (32), first bent halves thereof being inserted between said stripe conductor and said fins, and second bent halves of said film conductors being exposed toward said third electrode; and insulating means (52) for insulating said film conductors from said stripe conductor and said fins, said first conductor and said second conductor means being pressed toward each other, whereby to establish pressed contact of said first conductor with said first electrodes and said stripe conductor with said second electrodes, and to contact said film conductors with said third electrodes individually by spring force thereof.

8. The parallel connection structure as claimed in claim 7, further comprising connecting means, made of same material with said film conductors, for connecting said film conductors at ends thereof.

9. The parallel connection structure as claimed in claim 7 or 8,wherein said semiconductor switch comprises a MOSFET, said first electrode comprises a drain electrode, said second electrode comprises a source electrode, and said third electrode comprises a gate electrode.

10. The parallel connection structure as claimed in claim 7 or 8, wherein said semiconductor switch comprises an IGBT, said first electrode comprises a drain electrode, said second electrode comprises a source electrode, and said third electrode comprises a gate electrode.

11. The parallel connection structure as claimed in claim 7 or 8, wherein said semiconductor switch comprises a thyristor, said first electrode comprises an anode, said second electrode comprises a cathode, and said third electrode comprises a gate electrode.

12. The parallel connection structure as claimed in claim 7 or 8, wherein said semiconductor switch comprises a bipolar transistor said first electrode comprises a collector electrode, said second electrode comprises an emitter electrode, and said third electrode comprises a base electrode.

## Patentansprüche

1. Parallelschaltungsstruktur zum Parallelschalten mehrerer flacher, plattenförmiger Halbleiterschalter (20), wobei jeder derselben eine erste Elektrode (21), die auf einer ersten Oberfläche des Halbleiterschalters ausgebildet ist, eine zweite Elektrode (22), die von einer zweiten Oberfläche des Halbleiterschalters vorsteht, und mehrere federnde dritte Elektroden (23), die an der zweiten Oberfläche ausgebildet und von der zweiten Elektrode isoliert sind, aufweist, wobei die Parallelschaltungsstruktur aufweist:
einen plattenförmigen ersten Leiter (11); und
eine zweite Leitereinrichtung (12), die einen Streifenleiter (41) und mehrere Folienleiter (31) aufweist, die mit dem Streifenleiter aufgeschichtet sind und davon elektrisch durch einen Isolator (51) getrennt sind,
wobei der erste Leiter und die zweite Leitereinrichtung zueinander gedrückt werden, um dadurch einen Druckkontakt des ersten Leiters mit den ersten Elektroden und des Streifenleiters mit den zweiten Elektroden herzustellen, und die Folienleiter einzeln mit den dritten Elektroden durch deren Federkraft in Kontakt zu bringen.

2. Parallelschaltungsstruktur nach Anspruch 1, die ferner Verbindungseinrichtungen, die aus demselben Material wie die Folienleiter bestehen, zum Verbinden der Folienleiter an deren jeweiligen Enden aufweist.

3. Parallelschaltungsstruktur nach Anspruch 1 oder 2, wobei der Halbleiterschalter einen MOSFET aufweist, die erste Elektrode eine Drain-Elektrode aufweist, die zweite Elektrode eine Source-Elektrode aufweist und die dritte Elektrode eine Gate-Elektrode aufweist.

4. Parallelschaltungsstruktur nach Anspruch 1 oder 2, wobei der Halbleiterschalter einen IGBT aufweist, die erste Elektrode eine Drain-Elektrode aufweist, die zweite Elektrode eine Source-Elektrode aufweist und die dritte Elektrode eine Gate-Elektrode aufweist.

5. Parallelschaltungsstruktur nach Anspruch 1 oder 2, wobei der Halbleiterschalter einen Thyristor aufweist, die erste Elektrode eine Anode aufweist, die zweite Elektrode eine Kathode aufweist und die dritte Elektrode eine Gate-Elektrode aufweist.

6. Parallelschaltungsstruktur nach Anspruch 1 oder 2, wobei der Halbleiterschalter einen bipolaren Transistor aufweist, die erste Elektrode eine Kollektor-Elektrode aufweist, die zweite Elektrode eine Emitter-Elektrode aufweist und die dritte Elektrode eine Basis-Elektrode aufweist.

7. Parallelschaltungsstruktur zum Parallelschalten mehrerer flacher, plattenförmiger Halbleiterschalter (20), wobei jeder derselben eine erste Elektrode (21), die auf einer ersten Oberfläche des Halbleiterschalters ausgebildet ist, eine zweite Elektrode (22), die von einer zweiten Oberfläche des Halbleiterschalters vorsteht, und mehrere elastische dritte Elektroden (23), die an der zweiten Oberfläche ausgebildet und von der zweiten Elektrode isoliert sind, aufweist, wobei die Parallelschaltungsstruktur aufweist: einen plattenförmigen ersten Leiter (11) und eine zweite, Leitereinrichtung (13), die einen Streifenleiter (42a) aufweist, mehrere Rippen (42b), die vom Streifenleiter vorstehen und zu ihm gebogen sind, mehrere gebogene Folienleiter (32), wobei deren erste Biegungshälften zwischen dem Streifenleiter und den Rippen eingefügt sind und zweite gebogenen Hälften des Folienleiters zur dritten Elektrode freiliegen; und Isolationseinrichtungen (52) zum Isolieren des Folienleiters vom Streifenleiter und den Rippen, wobei der erste Leiter und die zweite Leitereinrichtung zusammendrückt werden, um dadurch einen Druckkontakt des ersten Leiters mit den ersten Elektroden und des Streifenleiters mit den zweiten Elektroden herzustellen, und die Folienleiter einzeln mit den dritte Elektroden durch deren Federkraft in Kontakt zu bringen.

8. Parallelschaltungsstruktur nach Anspruch 7, die ferner verbindungseinrichtungen, die aus demselben Material wie die Folienleiter bestehen, zum Verbinden der Folienleiter an deren Enden aufweist.

9. Parallelschaltungsstruktur nach Anspruch 7 oder 8, wobei der Halbleiterschalter einen MOSFET aufweist, die erste Elektrode eine Drain-Elektrode aufweist, die zweite Elektrode eine Source-Elektrode aufweist und die dritte Elektrode eine Gate-Elektrode aufweist.

10. Parallelschaltungsstruktur nach Anspruch 7 oder 8, wobei der Halbleiterschalter einen IGBT aufweist, die erste Elektrode eine Drain-Elektrode aufweist, die zweite Elektrode eine Source-Elektrode aufweist und die dritte Elektrode eine Gate-Elektrode aufweist.

11. Parallelschaltungsstruktur nach Anspruch 7 oder 8, wobei der Halbleiterschalter einen Thyristor aufweist, die erste Elektrode eine Anode aufweist, die zweite Elektrode eine Kathode aufweist und die dritte Elektrode eine Gate-Elektrode aufweist.

12. Parallelschaltungsstruktur nach Anspruch 7 oder 8, wobei der Halbleiterschalter einen bipolaren Transistor aufweist, die erste Elektrode eine Kollektor-Elektrode aufweist, die zweite Elektrode eine Emitter-Elektrode aufweist und die dritte Elektrode eine Basis-Elektrode aufweist.

## Revendications

1. Structure de connexion en parallèle pour connecter en parallèle une pluralité de commutateurs à semi-conducteurs plats en forme de plaque (20), chacun d'entre eux comprenant une première électrode (21) formée sur une première surface dudit commutateur à semi-conducteurs, une deuxième électrode (22) faisait saillie à partir d'une deuxième surface dudit commutateur à semi-conducteurs, et une pluralité de troisièmes électrodes élastiques (23) formées sur ladite deuxième surface et isolées de ladite deuxième électrode, ladite structure de connexion en parallèle comprenant :
un premier conducteur en forme de plaque (11) ; et un
deuxième moyen conducteur (12) comprenant un conducteur en bande (41) et une pluralité de conducteurs en film (31) stratifiés avec ledit conducteur en bande et séparés électriquement de celui-ci par un isolateur (51),
ledit premier conducteur et ledit deuxième moyen conducteur étant pressés l'un vers l'autre, de façon à établir un contact pressé dudit premier conducteur avec lesdites premières électrodes et dudit conducteur en bande avec lesdites deuxièmes électrodes, et de façon à faire venir en contact lesdits conducteurs en film avec lesdites troisièmes électrodes individuellement par la force d'élasticité de celles-ci.

2. Structure de connexion en parallèle selon la revendication 1, comprenant de plus des moyens de connexion, réalisés dans le même matériau que lesdits conducteurs en film, pour connecter lesdits conducteurs en film aux extrémités respectives de ceux-ci.

3. Structure de connexion en parallèle selon la revendication 1 ou la revendication 2, dans laquelle ledit commutateur à semi-conducteurs comprend un MOSFET, ladite première électrode comprend une électrode de drain, ladite deuxième électrode comprend une électrode de source, et ladite troisième électrode comprend une électrode de grille.

4. Structure de connexion en parallèle selon la revendication 1 ou 2, dans laquelle ledit commutateur à semi-conducteurs comprend un IGBT, ladite première électrode comprend une électrode de drain, ladite deuxième électrode comprend une électrode de source, et ladite troisième électrode comprend une électrode de grille.

5. Structure de connexion en parallèle selon la revendication 1 ou 2, dans laquelle ledit commutateur à semi-conducteurs comprend un thyristor, ladite première électrode comprend une anode, ladite deuxième électrode comprend une cathode, et ladite troisième électrode comprend un électrode de grille.

6. Structure de connexion en parallèle selon la revendication 1 ou 2, dans laquelle ledit commutateur à semi-conducteurs comprend un transistor bipolaire, ladite première électrode comprend une électrode de collecteur, ladite deuxième électrode comprend une électrode d'émetteur, et ladite troisième électrode comprend une électrode de base.

7. Structure de connexion en parallèle pour connecter en parallèle une pluralité de commutateurs à semi-conducteurs plats en forme de plaque (20), chacun d'entre eux comprenant une première électrode (21) formée sur une première surface dudit commutateur à semi-conducteurs, une deuxième électrode (22) faisant saillie depuis une deuxième surface dudit commutateur à semi-conducteurs, et une pluralité de troisièmes électrodes élastiques (23) formées sur ladite deuxième surface et isolées de ladite deuxième électrode, ladite structure de connexion en parallèle comprenant un premier conducteur en forme de plaque (11) et un deuxième moyen conducteur (13) comprenant un conducteur en bande (42a), une pluralité d'ailettes (42b) faisant saillie depuis ledit conducteur en bande et incurvées vers celui-ci, une pluralité de conducteurs en film incurvés (32), des premières moitiés incurvées de ceux-ci étant insérées entre ledit conducteur en bande et lesdites ailettes, et des deuxièmes moitiés incurvées desdits conducteurs en film étant exposées vers ladite troisième électrode ; et des moyens d'isolement (52) pour isoler lesdits conducteurs en film dudit conducteur en bande et desdites ailettes, ledit premier conducteur et ledit deuxième moyen conducteur étant pressés l'un contre l'autre, de façon à établir. un contact pressé dudit premier conducteur avec lesdites premières électrodes et dudit conducteur en bande avec lesdites deuxièmes électrodes, et à faire venir en contact lesdits conducteurs en film avec lesdites troisièmes électrodes individuellement par la force d'élasticité de celles-ci.

8. Structure de connexion en parallèle selon la revendication 7, comprenant de plus des moyens de connexion, réalisés à l'aide du même matériau que lesdits conducteurs en film, pour connecter lesdits conducteurs en film aux extrémités de ceux-ci.

9. Structure de connexion en parallèle selon la revendication 7 ou 8, dans laquelle ledit commutateur à semi-conducteurs comprend un MOSFET, ladite première électrode comprend une électrode de drain, ladite deuxième électrode comprend une électrode de source, et ladite troisième électrode comprend une électrode de grille.

10. Structure de connexion en parallèle selon la revendication 7 ou 8, dans laquelle ledit commutateur à semi-conducteurs comprend un IGBT, ladite première électrode comprend une électrode de drain, ladite deuxième électrode comprend une électrode de source, et ladite troisième électrode comprend une électrode de grille.

11. Structure de connexion en parallèle selon la revendication 7 ou 8, dans laquelle ledit commutateur à semi-conducteurs comprend un thyristor, ladite première électrode comprend une anode, ladite deuxième électrode comprend une cathode, et ladite troisième électrode comprend une électrode de grille.

12. Structure de connexion en parallèle selon la revendication 7 ou 8, dans laquelle ledit commutateur à semi-conducteurs comprend un transistor bipolaire, ladite première électrode comprend une électrode de collecteur, ladite deuxième électrode comprend une électrode d'émetteur, et ladite troisième électrode comprend une électrode de base.
